# FASCICULE DE BREVET EUROPEEN

(11) **EP 0 631 388 B1**
(45) Date de publication et mention de la délivrance du brevet: **15.10.1997**
(21) Numéro de dépôt: 94401407.5
(22) Date de dépôt: 23.06.1994
(51) Int. Cl.: H03K 3/355

(54) **Circuit de génération d'une impulsion de sortie stabilisée en durée**
Schaltungsanordnung zum Erzeugen von langen stabilisierten Pulsen
Circuit to generate an output pulse which is stabilized in length

(30) Priorité: 23.06.1993 FR 9307601
(43) Date de publication de la demande: 28.12.1994
(73) Titulaire: SGS-THOMSON MICROELECTRONICS S.A., 94250 Gentilly (FR)
(72) Inventeur: Wuidart, Sylvie, F-94230 Cachan (FR); Do, Tien-Dung, F-94230 Cachan (FR)
(74) Mandataire: Schmit, Christian Norbert Marie

(56) Documents cités:
- EP-A- 0 015 364
- EP-A- 0 405 319
- DE-A- 2 620 187

## Description

La présente invention concerne un circuit de génération d'une impulsion de sortie stabilisée en durée.

L'invention trouve une application particulièrement avantageuse dans la réalisation de filtres et, plus généralement, à tous circuits exigeant une référence de temps fiable et stable, tels que les détecteurs de fréquence et les générateurs de signaux d'horloge de durée donnée.

Dans le but de générer une impulsion stabilisée en durée, on utilise, de manière tout à fait classique, des circuits mettant en jeu la reproductibilité des caractéristiques des circuits de charge et de décharge d'un condensateur pour déterminer les paramètres de l'impulsion de sortie obtenue après comparaison avec une impulsion d'entrée commandant le fonctionnement des circuits de charge et de décharge.

Toutefois, les circuits de génération connus de ce type comportent tous des circuits, comme des inverseurs de sortie, qui sont très sensibles aux variations de température et de procédé de fabrication, au point que le rapport entre la plus longue et la plus courte impulsion de sortie est très souvent de l'ordre de 6, et au mieux de 4,5 environ.

Aussi, le problème technique à résoudre pour l'objet de la présente invention est de proposer un circuit de génération d'une impulsion de sortie stabilisée en durée, du type comprenant un condensateur relié, d'une part, à un circuit de charge, et, d'autre part, à un circuit de décharge, lesdits circuits de charge et de décharge étant commandés par une impulsion d'entrée, circuit de génération qui permettrait d'obtenir une durée d'impulsion de sortie beaucoup plus stable pour des températures variant de -50°C à 125°C, quels que soient les procédés de fabrication, et ceci pour des tensions d'alimentation de 3 à 7 volts.

La solution au problème technique posé consiste, selon la présente invention, en ce que ledit circuit de génération comprend un comparateur constitué :
- d'un premier transistor polarisé par ledit condensateur, le condensateur étant, d'une part, déchargé à travers le circuit de décharge pour un premier niveau de l'impulsion d'entrée, et, d'autre part, chargé, pour un deuxième niveau de l'impulsion d'entrée, à travers le circuit de charge sous un courant fixe fourni par un premier miroir de courant d'un générateur de courant,
- un deuxième transistor, en série avec le premier transistor, ledit deuxième transistor étant, d'une part, bloqué pour le premier niveau de l'impulsion d'entrée, et, d'autre part, polarisé, pour le deuxième niveau de l'impulsion d'entrée, par une tension de polarisation fixe définie par un courant fourni par un deuxième miroir de courant dudit générateur de courant, ledit comparateur délivrant un signal de sortie présentant, pour le deuxième niveau de l'impulsion d'entrée, une composante de niveau variable, correspondant à la charge du condensateur, et dont les variations sont définies par l'intensité du courant de charge du condensateur et par la tension de polarisation du deuxième transistor, de sorte que, ledit signal de sortie du comparateur étant appliqué à des moyens logiques de comparaison à l'impulsion d'entrée, la durée de l'impulsion de sortie est déterminée par ladite intensité du courant de charge du condensateur et ladite tension de polarisation du deuxième transistor.

Ainsi, comme on le verra en détail plus loin, au lieu d'utiliser directement en sortie du condensateur un inverseur de sortie conventionnel présentant une grande variation de tension de seuil, l'invention met en oeuvre un comparateur polarisé par deux tensions complètement indépendantes dont les niveaux de polarisation, fixés par le générateur de courant via les miroirs de courant, sont donc très stables.

D'autres avantages et caractéristiques du circuit de génération conforme à l'invention vont être maintenant décrits en regard des dessins annexés, donnés à titre d'exemples non limitatifs.

La figure 1 est un schéma d'un circuit de génération d'une impulsion de sortie stabilisée en durée, objet de l'invention.

La figure 2 montre des chronogrammes représentant l'impulsion d'entrée (a), le signal de décharge et de charge du condensateur de polarisation du premier transistor du comparateur du circuit de la figure 1 (b), le signal de sortie du comparateur (c), le signal de sortie du comparateur après détection par un inverseur de sortie (d), et l'impulsion de sortie (e).

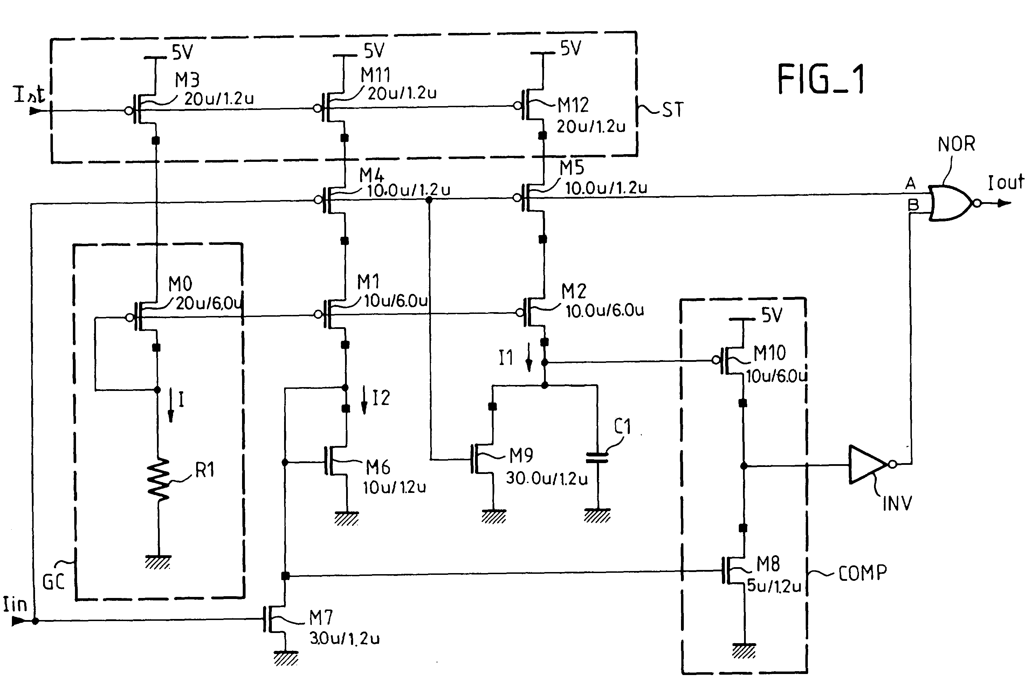

Le schéma de la figure 1 montre un circuit de génération d'une impulsion de sortie Iout stabilisée en durée. Ce circuit est du type comprenant un condensateur C1 relié d'une part à un circuit de charge constitué par un transistor M2 fonctionnant comme un premier miroir de courant d'un générateur de courant GC formé d'un transistor de commande M0 monté en diode en série avec une résistance R1 de 60 kΩ par exemple et commandant le transistor M2. D'autre part, le condensateur C1 est relié à un circuit de décharge constitué par un transistor M9 dont la source est à la masse. On notera sur la figure 1 que les drains des transistors représentés sont marqués d'un point noir. De même, on a indiqué pour chaque transistor la valeur du paramètre W/L.

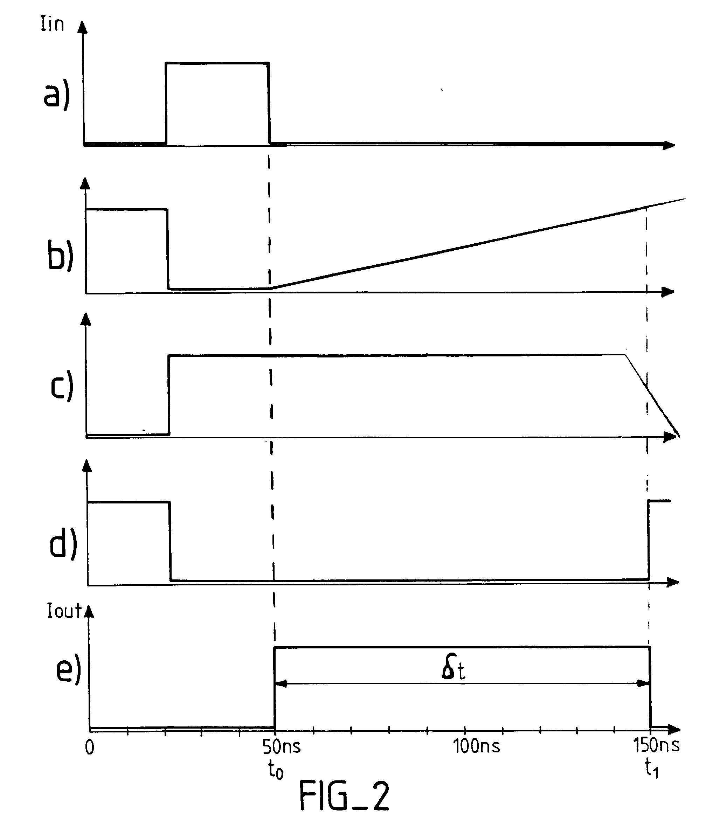

Comme le montre la figure 1, lesdits circuits de charge et de décharge sont commandés par une impulsion Iin appliquée à l'entrée du circuit de génération. En relation avec les chronogrammes (a) et (b) de la figure 2, on peut observer en effet que lorsque l'impulsion d'entrée Iin est à un premier niveau haut (+5V), le transistor M5 du type P, jouant le rôle d'interrupteur vis à vis du circuit de veille ST commandé par un signal Ist, est bloqué, aucun courant ne pouvant circuler dans le premier miroir de courant M2, tandis que le transistor M9, de type N, du circuit de décharge est conducteur provoquant ainsi la décharge du condensateur C1 avec une constante de temps très faible. A l'inverse, lorsque l'impulsion d'entrée Iin est à un deuxième niveau bas (0V), le transistor M9 de décharge est bloqué tandis que, l'interrupteur M5 devenant passant, le condensateur C1 est chargé sous un courant d'intensité Il fixe fourni par le premier miroir de courant M2. Dans l'exemple de réalisation montré à la figure 1, le courant I1, qui régit la vitesse de charge du condensateur C1, est la moitié du courant I délivré par le générateur de courant GC.

Conformément à la figure 1, la borne plus du condensateur C1 polarise un premier transistor M10, de type P, d'un comparateur COMP comprenant en outre un deuxième transistor M8, de type N, qui, pour le premier niveau haut de l'impulsion d'entrée Iin, est bloqué du fait que le transistor M7 de type N, est conducteur tandis que, pour le deuxième niveau bas de l'impulsion d'entrée Iin, le transistor M7 étant bloqué, le deuxième transistor M8 du comparateur COMP est polarisé par la tension de seuil Vt d'un transistor de polarisation M6 monté en diode et alimenté par un deuxième miroir de courant formé d'un transistor M1 commandé par le transistor M0 du générateur de courant. Selon le mode de réalisation de la figure 1, le courant fourni par le deuxième miroir de courant a une intensité I2 égale à la moitié du courant I délivré par le générateur de courant GC.

Ainsi, pour le premier niveau haut de l'impulsion d'entrée Iin, le condensateur C1 se décharge rapidement de sorte que le premier transistor M10, dont le potentiel de polarisation tombe à O, devient passant. Comme dans le même temps le deuxième transistor M8 est bloqué, le signal en sortie du comparateur COMP, représenté en (c) sur la figure 2, est à un niveau haut.

Lorsque l'impulsion d'entrée Iin est à son deuxième niveau bas, le condensateur C1 se chargeant, le premier transistor M10 devient de moins en moins passant à mesure que la tension de polarisation augmente. Dans le même temps, le deuxième transistor M8 devient légèrement passant du fait de sa polarisation à la tension de seuil Vt. Globalement, le signal de sortie du comparateur COMP est décrit selon des variations sensiblement linéaires définies par l'intensité I1 du courant de charge du condensateur C1 et par la tension de polarisation Vt du deuxième transistor M8.

La sortie du comparateur COMP est appliquée à un inverseur INV qui délivre à sa sortie le signal logique illustré en (d) sur la figure 2. La détection à t1 est fonction des deux paramètres I1 et Vt. Le signal fourni par l'inverseur INV est appliqué à une première borne d'une porte NOR, l'impulsion d'entrée Iin étant appliquée à une deuxième borne de la porte NOR de sorte que le signal de sortie de ladite porte est constitué par une impulsion Iout, représentée en (e) sur la figure 2, dont la durée δt = tn-to est déterminée par le courant I1 de charge du condensateur C1 et par la tension de polarisation Vt du deuxième transistor M8 du comparateur COMP.

Le circuit de génération de la figure 1 présente un certain nombre d'avantages contribuant à la stabilité en durée de l'impulsion de sortie Iout. Comme cela a déjà été souligné plus haut, le comparateur COMP est polarisé par deux niveaux complètement indépendants qui sont, de plus, déterminés par deux courants I1 et I2 fixes. En effet, le courant I fourni par le générateur de courant GC est très stable en procédé de fabrication car seul le transistor de commande M0 est utilisé. Le courant I est copié dans les miroirs de courant par les transistors M2 et M1 qui ont les mêmes rapport W/L.

On peut également observer que, dans le premier miroir de courant, seul le transistor M2 est utilisé pour charger le condensateur C1. Le transistor M9 ne sert qu'à décharger le condensateur C1 et donc n'influence en aucune manière la largeur de l'impulsion de sortie Iout. Seule la variation en procédé de fabrication du transistor M2 modifie le courant de charge I1 du condensateur C1.

Par ailleurs, le circuit de génération conforme à l'invention est le siège d'effets de compensation en température et en procédé de fabrication.

On sait que, lorsque la température augmente, les courants circulant dans les transistors sont plus faibles. Par conséquent, le courant I1 fourni par le premier miroir de courant étant moins grand, le condensateur C1 se charge plus lentement avec pour conséquence que le premier transistor M10 du comparateur COMP est polarisé plus faiblement d'où un rallongement du signal de sortie. Par contre, le transistor M8 du comparateur COMP est polarisé plus fortement car la tension de seuil Vt du transistor de polarisation M6 est plus grande, ce qui a pour effet de raccourcir le signal de sortie. D'où l'effet de compensation en température des deux transistors du comparateur, effet de compensation qui se produit également lorsque la température diminue.

Lors d'une variation du procédé de fabrication, la tension de seuil des transistors change ainsi que les courants y circulant. Ces caractéristiques varient avec le procédé de fabrication dans une fenêtre délimitée par un profil minimum et un profil maximum.

Dans le cas du profil minimum, les courants dans les transistors sont plus faibles et la valeur des tensions de polarisation plus forte.

Quand la tension Vt augmente, le transistor de polarisation M6 polarise plus fortement le deuxième transistor M8 du comparateur COMP. Mais celui-ci a également son propre seuil qui augmente, car le courant est plus faible, ce qui compense l'augmentation du Vt.

Quand la tension de seuil augmente, le courant I1 circulant dans le premier miroir de courant est plus fort, et la charge du condensateur C1 est plus rapide. Par contre, le premier transistor M10 du comparateur COMP ayant un courant plus faible à cause du seuil qui augmente, il y a compensation en procédé de fabrication.

De même dans le cas du profil maximum : il se produit une compensation du transistor M7 par le transistor M8 et du transistor M2 par le transistor M10.

Les transistors M3, M11 et M12 sont utilisés dans un circuit de veille ST (ou Standby en anglo-saxon). Dans ce mode, aucune génération de courant ne se produit. Les transistors M4 et M5 sont utilisés en mode de pseudo-veille, c'est-à-dire que la consommation dans les deux miroirs de courant est limitée à une demi-période de l'impulsion d'entrée Iin, quand celle-ci est au niveau bas.

En fonctionnement normal, la consommation est constante dans le générateur de courant GC. Bien entendu, cette consommation aurait pu être limitée à une demi-période de l'impulsion d'entrée, comme pour les miroirs de courant. Cependant, on augmente ainsi le risque de perturbation et de mauvais fonctionnement du circuit en régime dynamique. C'est pourquoi il est préférable de choisir la perte de consommation en faveur d'un courant plus stable, et donc d'une impulsion de sortie Iout plus stable.
Dans une application pratique on a :
- I =: 44 microampères (stable)
- I1 =: 20 microampères (stable)
- I2 = 17: microampères et O microampère quand C1 est chargée
- C1 =: 400 10⁻¹⁵ farads
- Vt =: 0,83 volt pour les transistors N
1,049 volt pour les transistors P
(procédé de fabrication type, à 25°C, pour Vcc=25volts)

## Revendications

1. Circuit de génération d'une impulsion de sortie (Iout) stabilisée en durée, du type comprenant un condensateur (C1) relié, d'une part, à un circuit (M5, M2) de charge, et, d'autre part, à un circuit (M9) de décharge, lesdits circuits de charge et de décharge étant commandés par une impulsion d'entrée (Iin), caractérisé en ce que ledit circuit de génération comprend un comparateur (COMP) constitué :
- d'un premier transistor (M10) polarisé par ledit condensateur (C1), le condensateur étant, d'une part, déchargé à travers le circuit (M9) de décharge pour un premier niveau de l'impulsion d'entrée (Iin), et, d'autre part, chargé pour un deuxième niveau de l'impulsion d'entrée, à travers le circuit (M5, M2) de charge sous un courant fixe (I1) fourni par un premier miroir de courant (M2) d'un générateur de courant (GC).
- d'un deuxième transistor (M8), en série avec le premier transistor (M10), ledit deuxième transistor étant, d'une part, bloqué pour le premier niveau de l'impulsion d'entrée (Iin), et, d'autre part, polarisé, pour le deuxième niveau de l'impulsion d'entrée, par une tension de polarisation fixe définie par un courant fourni (I2) par un deuxième miroir de courant (M1) dudit générateur de courant (GC), ledit comparateur (COMP) délivrant un signal de sortie présentant, pour le deuxième niveau de l'impulsion d'entrée (Iin), une composante de niveau variable, correspondant à la charge du condensateur (C1), et dont les variations sont définies par l'intensité (I1) du courant de charge du condensateur (C1) et par la tension de polarisation du deuxième transistor (M8), de sorte que, ledit signal de sortie du comparateur (COMP) étant appliqué à des moyens logiques (INV, NOR) de comparaison de l'impulsion d'entrée (Iin), la durée de l'impulsion de sortie (Iout) est déterminée par ladite intensité (I1) du courant de charge du condensateur (C1) et ladite tension de polarisation du deuxième transistor (M8).

2. Circuit de génération selon la revendication 1, caractérisé en ce que ledit générateur de courant (GC) est constitué par un transistor de commande (MO) monté en diode.

3. Circuit de génération selon l'une des revendications 1 ou 2, caractérisé en ce que ladite tension de polarisation du deuxième transistor (M8) du comparateur (COMP) est une tension de seuil d'un transistor de polarisation (M6) alimenté par le courant (I2) fourni par le deuxième miroir de courant (M1).

4. Circuit de génération selon l'une quelconque des revendications 1 à 3, caractérisé en ce que les premier et deuxième miroirs de courant comprennent, chacun, un transistor (M2, M1) polarisé par ledit transistor de commande (M0).

## Patentansprüche

1. Generatorschaltkreis für einen zeitlich stabilisierten Ausgangsimpuls (Iout), der einen Kondensator (C1) umfaßt, welcher auf einer Seite mit einem Ladeschaltkreis (M5, M2) und auf der anderen Seite mit einem Entladeschaltkreis (M9) verbunden ist, wobei der Lade- und der Entladeschaltkreis durch einen Eingangsimpuls (Iin) angesteuert wird,
dadurch gekennzeichnet, daß
der Generatorschaltkreis einen Komparator (COMP) umfaßt, der aufweist:
- einen ersten Transistor (M10), der durch den Kondensator (C1) vorgespannt wird, wobei der Kondensator einerseits über den Entladeschaltkreis (M9) auf ein erstes Niveau des Eingangsimpulses (Iin) entladen wird und andererseits bei festem Strom (I1) von einem ersten Stromspiegel (M2) eines Stromgenerators (GC) auf ein zweites Niveau des Eingangsimpulses über den Ladeschaltkreis (M5, M2)aufgeladen wird,
- einen zweiten Transistor (M8), der in Serie geschaltet ist mit dem ersten Transistor (M10), wobei der zweite Transistor einerseits bei dem ersten Niveau des Eingangsimpulses (Iin) sperrt und andererseits bei dem zweiten Niveau des Eingangsimpulses durch eine feste Vorspannung die durch einen Strom (I2) definiert wird, der durch einen zweiten Stromspiegel (M2) des besagten Stromgenerators (GC) ausgegeben wird, vorgespannt wird, wobei der Komparator (COMP) ein Ausgangssignal ausgibt, das bei dem zweiten Niveau des Eingangsimpulses (Iin) eine Komponente mit variablem Niveau ist, und der Ladung des Kondensators (C1) entspricht, und dessen Schwankungen durch die Stärke (I1) des Ladestroms des Kondensators (C1) und durch die Vorspannung des zweiten Transistors (M8) definiert sind, so daß bei an die Logikvorrichtungen (INV, NOR) zum Vergleichen des Eingangsimpulses angelegtem Ausgangssignal des Komparators (COMP) die Dauer des Ausgangsimpulses (Iout) bestimmt wird durch die Stärke (I1) des Ladestroms des Kondensators (C1) und die Vorspannung des zweiten Transistors (M8).

2. Generatorschaltkreis nach Anspruch 1, dadurch gekennzeichnet, daß der Stromgenerator (GC) einen Steuertransistor (M0) aufweist, der als Diode geschaltet ist.

3. Generatorschaltkreis nach einem der Ansprüche 1 oder 2, dadurch gekennzeichnet, daß die Vorspannung des zweiten Transistors (M8) des Komparators (COMP) eine Schwellenspannung eines Vorspannungstransistors (M6) ist, der durch den Strom (I2) versorgt wird, der durch den zweiten Stromspiegel (M1) ausgegeben wird.

4. Generatorschaltkreis nach einem der Ansprüche 1 bis 3, dadurch gekennzeichnet, daß der erste und zweite Stromspiegel jeweils einen Transistor (M2, M1) umfaßt, der durch den Steuertransistor (M0) vorgespannt wird.

## Claims

1. A circuit for generating a width-stabilised output pulse (Iout), of the type comprising a capacitor (C1) connected, firstly, to a charging circuit (M5, M2), and, secondly, to a discharging circuit (M9), the said charging and discharging circuits being controlled by an input pulse (Iin),
**characterised in that t**he said generating circuit comprises a comparator (COMP) formed:
- by a first transistor (M10) biased by the said capacitor (C1), the capacitor being, firstly, discharged through the circuit (M9) for a first level of the input pulse (Iin), and, secondly, charged for a second level of the input pulse, through the charging circuit (M5, M2) under a fixed current (I1) supplied by a first current mirror (M2) of a current generator (GC).
- by a second transistor (M8), in series with the first transistor (M10), the said second transistor being, firstly, inhibited for the first level of the input pulse (Iin) and, secondly, biased for the second level of the input pulse, by a fixed bias defined by a current supplied by a second current mirror (M1) of the said current generator (GC), the said comparator (COMP) supplying an output signal having, for the second level of the input impulse (Iin), a variable level component, corresponding to the charge of the capacitor (C1), and the variations of which are defined by the intensity (I1) of the charging current of the capacitor (C1) and by the bias of the second transistor (M8), so that, the said output signal of the comparator (COMP) being applied to logic means (INV, NOR) for comparing the input pulse (Iin), the width of the output pulse is determined by the said intensity (I1) of the charging current of the capacitor (C1) and the said bias of the second transistor.

2. A generating circuit according to Claim 1,
**characterised in that** the said current generator (GC) is formed by a control transistor (M0) configured as a diode.

3. A generating circuit according to one of Claims 1 or 2,
**characterised in that** the said bias of the second transistor (M8) of the comparator (COMP) is a threshold voltage of a biasing transistor (M6) supplied by the current (I2) provided by the second current mirror (M1).

4. A generating circuit according to any one of Claims 1 to 3,
**characterised in that** the first and second current mirrors each comprise a transistor (M2, M1) biased by the said control transistor (MO).
